# EUROPEAN PATENT SPECIFICATION

(11) **EP 0 703 664 B1**
(45) Date of publication and mention of the grant of the patent: **04.12.2002**
(21) Application number: 95114786.7
(22) Date of filing: 20.09.1995
(51) Int. Cl.: H03K 17/08, H02M 7/48, H03K 17/082

(54) **Semiconductor circuit**
Halbleiterschaltung
Circuit semi-conducteur

(30) Priority: 20.09.1994 JP 22475394
(43) Date of publication of application: 27.03.1996
(73) Proprietor: Hitachi, Ltd., Chiyoda-ku, Tokyo 101 (JP); HITACHI HARAMACHI ELECTRONICS CO., LTD., Hitachi-shi, Ibaraki 317 (JP)
(72) Inventor: Hitoshi, Ohura, Hitachi-shi, Ibaraki 316 (JP); Koji, Kawamoto, Hitachi-shi, Ibaraki 317 (JP); Shoichi, Ozeki, Hitachi-shi, Ibaraki 316 (JP)
(74) Representative: Beetz & Partner Patentanwälte

(56) References cited:
- PATENT ABSTRACTS OF JAPAN vol. 010, no. 005 (E-372), 10 January 1986 & JP-A-60 167522 (HITACHI SEISAKUSHO KK;OTHERS: 01), 30 August 1985,
- PATENT ABSTRACTS OF JAPAN vol. 009, no. 266 (E-352), 23 October 1985 & JP-A-60 112318 (NIPPON DENKI KK), 18 June 1985,
- PATENT ABSTRACTS OF JAPAN vol. 012, no. 337 (E-657), 12 September 1988 & JP-A-63 099779 (FUJI ELECTRIC CO LTD), 2 May 1988,
- PATENT ABSTRACTS OF JAPAN vol. 012, no. 465 (E-690), 7 December 1988 & JP-A-63 187815 (HITACHI LTD), 3 August 1988,
- CHOKHAWALA R ET AL: "GATE DRIVE CONSIDERATIONS FOR IGBT MODULES" 4 October 1992 , PROCEEDINGS OF THE INDUSTRY APPLICATIONS SOCIETY ANNUAL MEETING, HOUSTON, OCT. 4 - 9, 1992, VOL. 1, PAGE(S) 1186 - 1195 , INSTITUTE OF ELECTRICAL AND ELECTRONICS ENGINEERS XP000368921 * page 1194, paragraph F - page 1195; figure 1 *

## Description

The present invention relates to a semiconductor circuit utilizing a MOSFET and a semiconductor device of IGBT type and monolithic semiconductor integrated circuits comprising this circuit.

As for the voltage drive type semiconductor devices such as insulated gate bipolar transistors (hereinafter called IGBT), MOS type field-effect transistors (hereinafter called MOSFETs), etc., high-speed switching thereof is possible. Therefore, the devices may be driven with a high frequency if the semiconductor device is for example applied to an inverter apparatus for driving a motor. Accordingly, size and weight of the devices and their noise development may be minimized. However, in high frequency inverter apparatus, when the semiconductor device is switched on and off, a large voltage change dV/dt is applied suddenly to the semiconductor device. Then the IGBT and the MOSFET may show malfunction and turn on in a period where they should be turned off originally. In this case, a short-circuit accident of the upper or the lower arm of the inverter apparatus may occur. And, in the case of monolithic semiconductor integrated circuits in which the circuit of the inverter apparatus is monolithically provided as one semiconductor chip, the semiconductor chip may be destroyed.

A conventional technology for preventing such failures of semiconductor apparatus of this type is described in JP-A-63-99779 (1989) for example.

This document shows a circuit for biasing the gate of the MOSFET by connecting the MOSFET between the gate and the emitter of the IGBT of the main circuit and by connecting the gate of the MOSFET to a power supply for driving the gate of the IGBT through a resistor element. By this circuit, when the IGBT is in the OFF state, the gate of the MOSFET biased, and the MOSFET is switched on, a short-circuit is provided between the gate and the emitter of the IGBT. Thereby, even if a large voltage change dV/dt is applied between the collector and the emitter of the IGBT, the IGBT does not show such a failure.

However, in the conventional technology, when the IGBT is in the OFF state, the electric power consumption increases because the MOSFET is always set up as in the ON state. Furthermore, a resistor element having a high resistance value and a high withstand voltage becomes necessary, and the chip area becomes large when the inverter circuit is implemented in the form of a monolithic circuit.

It is the underlying problem of the present invention to overcome the disadvantages of the prior art mentioned above and to provide a semiconductor circuit and its implementation in monolithic form, which leads to a lower electric power consumption of the circuit and a reduction of the chip area in the case of monolithics.

The above problem is solved according to the independent claims. The dependent claims relate to preferred embodiments of the concept of the present invention.

The semiconductor circuit of the present invention comprises a first semiconductor device having a pair of main electrodes and an insulated gate electrode, and a second semiconductor device having a first main electrode, a second main electrode and a control electrode. Here, the first main electrode of the second semiconductor device is connected to the insulated gate electrode of the first semiconductor device, and the second main electrode of the second semiconductor device is connected to one of the main electrodes of the first semiconductor device.

A capacity element is connected between the control electrode of the second semiconductor device and an electric settling potential.

In the integrated circuit of the present invention, the semiconductor circuit of the present invention described above is formed on the same semiconductor substrate.

According to the semiconductor circuit of the present invention, when the voltage applied to the two main electrodes of the first semiconductor device changes, an electric displacement current flows in a capacity element. Because this electric displacement current is supplied as a control signal to the control electrode of the second semiconductor device, the second semiconductor device is turned on. By this the insulated gate electrode of the first semiconductor apparatus is short-circuited with one of its main electrodes, and therefore, turn-on of the first semiconductor device by a transient voltage dV/dt (failure, malfunction) may be prevented.

In the following, the present invention will be explained with reference to the drawings.
- Fig. 1: is an example of the basic circuit of the present invention.
- Fig. 2: is the circuit constitution of one embodiment of the present invention.
- Fig. 3: shows the operation conditions of the circuit shown in Fig. 2.
- Fig. 4: shows the operational conditions of the circuit shown in Fig. 2 when a transient voltage change arises.
- Fig. 5: is another embodiment according to the present invention.
- Fig. 6: is an embodiment of a monolithic inverter circuit for driving a three phase brushless motor using the circuit shown in Fig. 5.
- Fig. 7: is an example of the pattern layout of the monolithic IC shown in Fig. 6.
- Fig. 8: ist another embodiment according to the present invention.

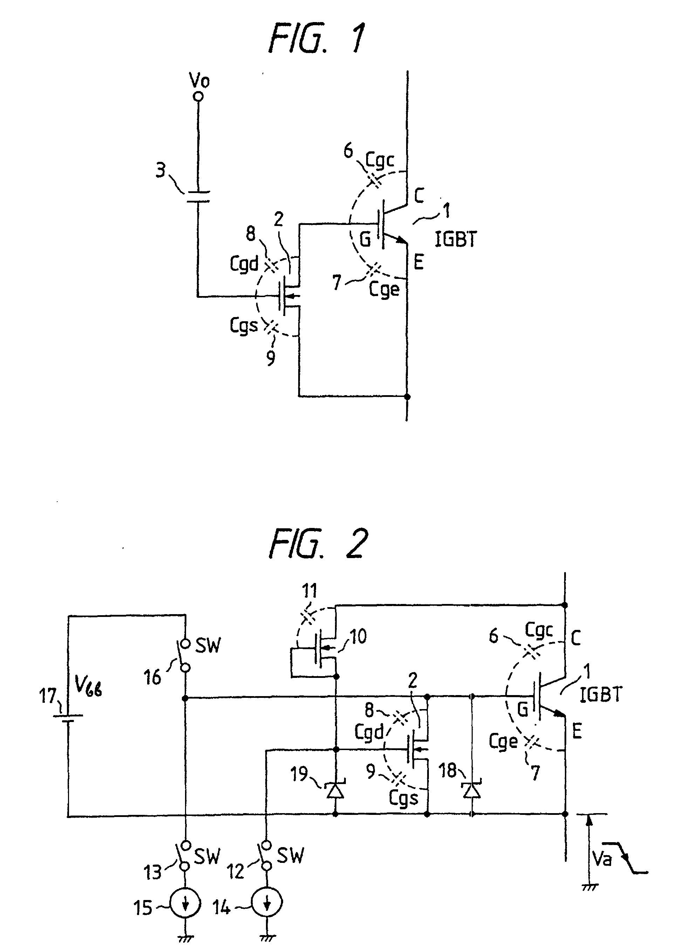

The operation of the semiconductor circuit of the present invention will be explained with reference to Fig. 1.

Fig. 1 is an example of the basic circuit of the present invention. When a transiently changing voltage is applied to the collector C and the emitter E (pair of main electrodes) of the IGBT 1 (the first semiconductor device), an electric displacement current flows through the capacitor 3 (the capacity element), the MOS gate (the control electrode) of a MOSFET 2 (the second semiconductor device) for a gate short-circuit and the source electrode (the second main electrode) between the settling electric potential Vₐ and the emitter electrode E (one of the main electrodes) of the IGBT 1. The parasitic capacitances 8 and 9 are charged by the electric displacement current, and the state between the drain electrode (the first main electrode) and the source electrode of the MOSFET 2 becomes ON. On the other hand, in the IGBT 1, the parasitic capacitances Cgc 6, Cge 7 are charged in the same way. However, as the gate and the emitter of the MOS gate (the insulated gate electrode) IGBT 1 are short-circuited through the switching of the MOSFET 2 into the ON state, the electric charges of the parasitic capacitances are discharged through the MOSFET 2. Accordingly, the IGBT 1 is not switched on because the gate voltage of the IGBT does not rise.

As the electric displacement current flows only when the voltage chages, the electric power consumption of the circuit is reduced.

Further, according to the integrated circuit of the present invention where the semiconductor circuit of the present invention is provided on a semiconductor substrate, a protection circuit portion may be provided using a resistance element having a high resistance value or a high withstanding voltage. Accordingly, the chip area may be reduced.

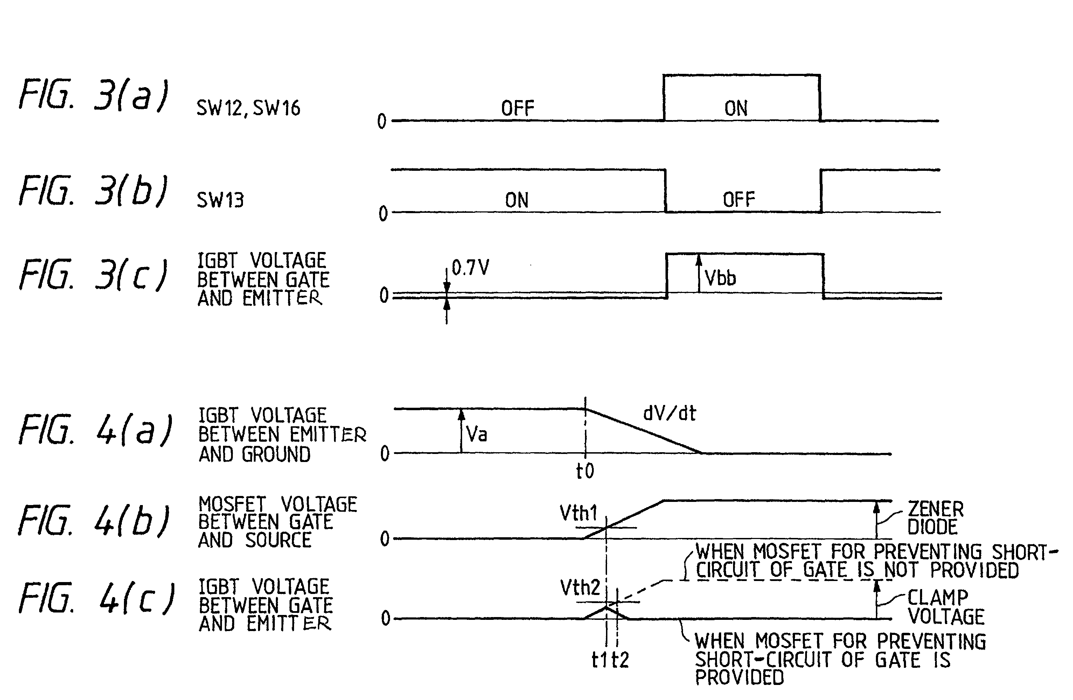

The constitution of a circuit being an embodiment of the present invention is shown in Fig. 2. The operational conditions of the circuit are shown in Fig. 3, and the change thereof upon a transient change of the voltage, dV/dt, is shown in Fig. 4.

In this embodiment, a MOSFET is used as the capacity element, one end thereof is connected to the collector voltage of the IGBT 1.

At first, the operation will be explained when the IGBT 1 is ON. As shown in the waveform diagrams of Fig. 3, the switches 12, 16 are ON. The switch 16 supplies the voltage Vbb from a main power supply 17 to the gate G of the IGBT 1. With the switch 12 closed the electric charge accumulated between the gate and the source of the MOSFET 2 for a gate short-circuit is pulled up by a constant current source 14 and works to surely make the MOSFET 2 OFF. The switsch 13 is OFF in order to prevent an overlapping with the switch 16.

The changes will now be explained when the IGBT 1 is switched OFF next. In the circuit operation conditions shown in Fig. 3, the switch 12 is OFF, the switch 13 is ON, and the switch 16 is OFF. Actually, semicondcutor switching elements are used for these switches here. A constant current flows into a constant current source 15 through a Zener diode 18 by switching on the switch 13, and a reverse bias of approximately 0.7 V is added between the gate and the emitter of the IGBT 1. On the other hand, as the switch 12 is OFF, the gate of the MOSFET 2 transiently changes toward the voltage that is defined by the division ratio of the parasitic capacitance 11 of the N-MOSFET 10 to the parasitic capacity 8 (Cgd) and 9 (Cgs) of the MOSFET 2. However, it is clamped by the Zener voltage of the Zener diode 19.

Fig. 4 shows the changes in the operation conditions when the voltage Va between the emitter of the IGBT 1 and the ground transiently descends from an arbitrary voltage Vx to 0 V. Here, the initial condition of the electric charge of the parasitic capacities of 8 and 9 of the MOSFET 2 for gate short-circuit is defined as zero. When, in Fig. 4, a descent of the voltage occured at the time point of tO, the parasitic capacitance 1 and the parasitic capacities 8 and 9 of the MOSFET 2 for the gate short-circuit are started to be charged with the electric charge, the voltage between the gate and the source of the MOSFET 2 rising as shown in Fig. 4 (b). When this voltage is increased up to the threshold level (Vth1) of the MOSFET 2, the MOSFET 2 is switched on. On the other hand, as shown in Fig. 4 (c), the voltage between the gate and the emitter of the IGBT 1 rises in the same way by charging the parasitic capacity of 6 (Cgc) and 7 (Cge) with electric charge. If the MOSFET 2 is not provided, then the voltage between the gate and the emitter of the IGBT 1 changes like the dotted line of Fig. 4 (c), exceeds the threshold voltage level (Vth2) of the gate of the IGBT 1, and the IGBT 1 turns on. On the other hand, when the MOSFET 2 for the gate short-circuit is provided, it turns on at tl, and the IGBT 1 is short-circuited, and then the parasitic capacity 7 is discharged, and the voltage between the gate and the emitter of the IGBT 1 does not reach the threshold voltage level so as not to turn on the IGBT 1. Accordingly, false operation or malfunction because of a transient voltage dV/dt may be prevented.

In the capacitance element of this embodiment, a power loss can hardly occur, or, is pretty small compared to the case of using a resistance element. Therefore, according to this embodiment, the electric power consumption can be reduced. Furthermore, because this embodiment uses the capacitance of the MOSFET 10 as the capacitance element, if applied to an integrated circuit, the size of the chip can be reduced too.

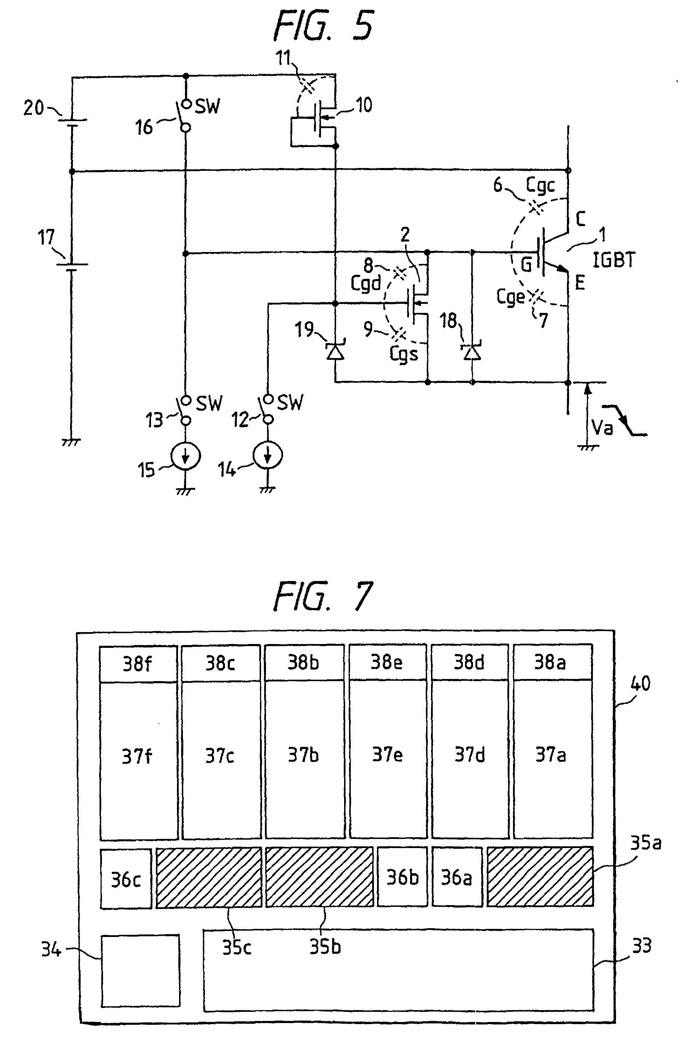

Another embodiment of the present invention is shown in Fig. 5. The N-MOSFET 10 is used as the capacitance element in this embodiment too, one end thereof being connected to the voltage of the power supply for gate drive. That is, a power supply 20 for driving the gate of the IGBT 1 is connected to the higher potential side of the main power supply 17, and the drain of the N-MOSFET 10 is connected to the higher potential side of the power supply 20 for driving the gate of this IGBT 1.

In the following, the change of the operation conditions of this embodiment will be explained when a transient voltage change dV/dt is generated. When the IGBT 1 is in the OFF state, the switches 16, 12 are OFF, and the switch 13 is ON in the same way as in Fig. 2. The parasitic capacitance 11 of the N-MOSFET 10 is charged by a voltage of [(the voltage of the main power supply 17 + the voltage of the power supply 20 for driving the IGBT)-(Va + Zener voltage of the Zener diode 19)]. When the voltage change dV/dt is generated, the change in the operation conditions is similar as in the case of the former embodiment.

In this embodiment, because the MOSFET used as the capacitance element for malfunction prevention is connected to the gate circuit side, any interference between the main circuit side and the gate circuit side through this capacitance element is hard to happen. On this account, when the circuit of this embodiment is constructed in the form of a monolithic circuit comprised in the semiconductor chip, it becomes easy to design the layout of the element as the main circuit part and the gate circuit part do not interfere with each other.

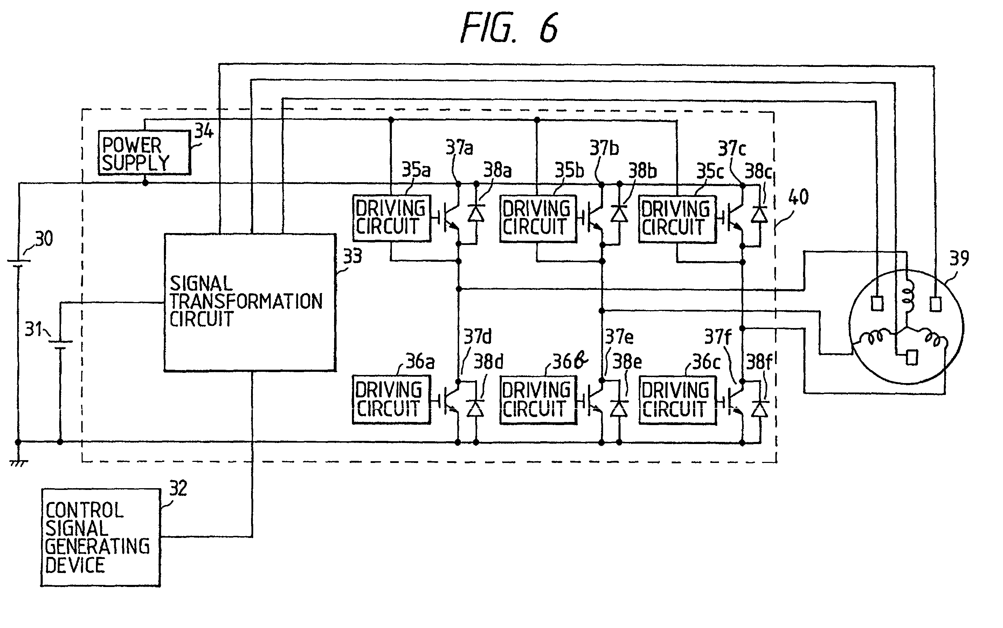

Fig. 6 shows an embodiment of a monolithic inverter circuit 40 shown with a dotted line for driving a 3-phase brushless motor using the circuit shown in Fig. 5. In Fig. 6, the power supply 30 for driving the motor is a power supply for driving the 3-phase brushless motor 39 in which a hall element for detecting the magnetic pole position of the rotor is built in. The power supply 30 for driving the motor 39 is connected with a 3-phase bridge circuit which is constructed with the IGBTs 37a to 37f and free-running diodes 38a to 38f which are connected in direction in parallel to the main electrodes of the IGBTs 37a to 37f, respectively. The power supply 31 for the monolithic IC control is a power supply for driving a signal transformation circuit 33 which receives and divides the output signal from the gate drive circuits 36a to 36c of the IGBTs 37d to 37f of the lower arm and from the hall element provided in the motor 39. The power supply circuit 34 is a circuit for generating the voltage supplied to the gate drive circuits 35a to 35c of the upper arm IGBTs 37a to 37c. Accordingly, the apparatus constitution becomes simple because an external gate power supply for the upper arm becomes unnecessary. Further, the control signal generating device 32 of the monolithic IC is a circuit for controlling the ON-OFF duty ratio of the IGBTs of each arm. The inner part encircled by the broken line is constructed with the monolithic IC 40 in the figure.

The parts provided with a circuit shown in Fig. 5 in the above-mentioned circuit correspond to upper arm drive circuits 35a to 35c. The power supply 20 for driving the IGBT in Fig. 5 corresponds to the power supply 34 of this embodiment here. In other words, the circuit of Fig. 5 is suitable for use in inverter circuits as shown in Fig. 6. In this embodiment with the bridge constitution as shown in Fig. 6, any malfunction of the IGBTs in the upper arm cannot arise even if a transient voltage dV/dt is applied by a chopping of the IGBTs 37a to 37f of the lower arm.

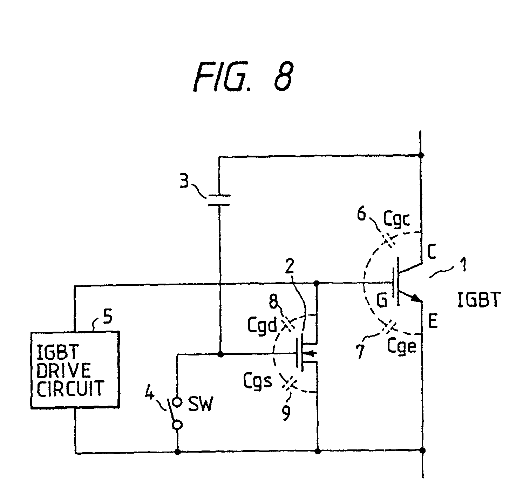

Fig. 7 shows an example of the pattern layout of the monolithic IC 40 in Fig. 6. The symbols in this figure correspond to those in Fig. 6, and the upper arm drive circuit corresponds to the driving circuits 35a to 35c of the hatched part of Fig. 7. The malfunction prevention circuit as shown in Fig. 5 forms the driving circuits 35a to 35c. Accordingly, in the circuits using resistance elements in the conventional way, both chip size and electric power consumption thereof become pretty big, because a plurality of resistance elements having a high withstanding voltage and a high resistance value are necessary. On the contrary, in this embodiment, as the circuit is constructed with the capacitance of the MOSFET, the chip size and the electric power consumption can be reduced as compared to the conventional circuit arrangement.

Fig. 8 shows a semiconductor circuit according to another embodiment of the present invention. Between the gate of the MOSFET 2 and the collector C of the IBGT 1, a usual capacitor 3 (dielectric member provided between two metal electrodes) is connected. From the capacitor 3 an electric current flows only when a transient voltage dV/dt occurs between the collector C and the emitter E of the IGBT 1, and the parasitic capacitances Cgd 8, Cgd 9 between the gate and the drain and the source of the MOSFET 2 are charged so as to turn on the MOSFET 2. As means for turning off the MOSFET 2 for gate short-circuit, in addition to the above measures, a switch SW 4 is provided between the gate and the drain of the MOSFET 2 for discharging the electric charge of the parasitic gate capacitances 8 and 9 of the MOSFET 2. As the switch SW 4, a semiconductor switching element is used. According to a signal for controlling the switch 4 and the IGBT drive circuit 5, the IGBT 1 is turned off within a period for protecting the IGBT 1 from the transient voltage dV/dt during its OFF period, and is turned on within a period of ON state of the IGBT 1.

In the above-mentioned embodiment, the switching element of the main circuit is the IGBT, however, the present invention may be applied also to cases where an insulated gate type semiconductor device such as a MOSFET is used for the main circuit.

In addition, the present invention may be applied to not only the inverter devices, but also to other apparatus in which a transient voltage dV/dt is applied to a switching element thereof. Furthermore, the circuit used in these apparatus is effective in cases where it is used not only as an integrated circuit, but also as a single body element or a modular construction.

In addition to the above, in the present invention, the circuit that consists of the semiconductor device for the gate short-circuit and the capacitance element operates as a kind of dV/dt detection circuit. Therefore, according to the output signal of such a detection circuit, malfunction of the main circuit semiconductor device may be prevented by putting out an OFF control signal from the drive circuit of the semiconductor device of the main circuit.

According to the semiconductor circuit of the present invention, because the operational behavior of the gate short-circuit, malfunctions of the semiconductor device are prevented only when a transient voltage dV/dt occurs; therefore, the electric power consumption is effectively reduced as compared with the conventional technology.

In addition thereto, monolithic semiconductor integrated circuits of the present invention lead to an effective reduction of the chip area because resistance elements of high withstanding voltage and of high resistance value requiring a big cell area are no longer necessary.

## Claims

1. Semiconductor circuit comprising:
- a first voltage drive type semiconductor device (IGBT, 1) having a pair of main electrodes (C, E) and an insulated gate electrode (G),
- a second voltage drive type semiconductor device (MOSFET, 2) having a first main electrode, a second main electrode and a control electrode, the first main electrode being connected to the insulated gate electrode (G) of the first voltage drive type semiconductor device (IGBT, 1), and the second main electrode being connected to one of the main electrodes (E) of the first voltage drive type semiconductor device (IGBT, 1), and
- a capacity element (3) connected between the control electrode of the voltage drive type second semiconductor device (MOSFET, 2) and an electric settling potential (Va), whereby the second voltage drive type semiconductor device (MOSFET, 2) is turned on.

2. Semiconductor circuit according to claim 1,
**characterized in that**
the electric settling potential (Va) is applied to the other main electrode (E) of the first voltage drive type semiconductor device (IGBT, 1).

3. Semiconductor circuit according to claim 1,
**characterized in that**
the electric settling potential is applied to a driving circuit of the first voltage drive type semiconductor device (IGBT, 1).

4. Semiconductor circuit according to any of claims 1 to 3,
**characterized in that**
the capacity element (3) is constructed with a MOS type field-effect transistor (10).

5. Semiconductor circuit according to any of claims 1 to 3,
**characterized in that**
the capacity element (3) is a capacitor.

6. Semiconductor circuit according to any of claims 1 to 5,
**characterized in that**
the first voltage drive type semiconductor device (IGBT, 1) is an insulated gate bi-polar transistor.

7. Semiconductor circuit according to any of claims 1 to 5,
**characterized in that**
the first voltage drive type semiconductor device is a MOS type field-effect transistor.

8. Semiconductor circuit according to any of claims 1 to 7,
**characterized in that**
the second voltage drive type semiconductor device is a MOS type field-effect transistor (MOSFET, 2).

9. Semiconductor circuit according to any of claims 1 to 7,
**characterized in that**
the second voltage drive type semiconductor device is an insulated gate bi-polar transistor.

10. Semiconductor circuit, comprising:
- a plurality of first voltage drive type semiconductor devices connected in series and connected to a direct current power supply having a pair of main electrodes and an insulated gate electrode, wherein an output is taken out from the series connection point of the first voltage drive type semiconductor devices,
- a second voltage drive type semiconductor device having a first main electrode, a second main electrode and a control electrode, the first main electrode being connected to the insulated gate electrode of at least one of the first voltage drive type semiconductor devices, and the second main electrode being connected to one of the main electrodes of one of the voltage drive type first semiconductor devices, and
- a capacity element connected between the control electrode of the voltage drive type second semiconductor device and an electric settling electric potential, whereby the second voltage drive type semiconductor device (MOSFET, 2) is turned on.

11. Inverter circuit, comprising one or a plurality of semiconductor circuits according to one of claims 1 to 10.

12. Monolithic semiconductor circuit, **characterized by** one or a plurality of semiconductor circuits according to one of claims 1 to 10 or one or a plurality of inverter circuits according to claim 11, provided on the same semiconductor substrate.

13. Use of the semiconductor circuits according to claims 1 to 12 for apparatus comprising one or a plurality of semiconductor switching devices for protection of the semiconductor switching devices against failure or malfunction through gate short-circuit in the case of occurrence of a dangerous transient voltage (dV/dt).

## Patentansprüche

1. Halbleiterschaltung mit
- einer ersten spannungssteuerungsartigen Halbleitervorrichtung (IGBT, 1) mit zwei Hauptelektroden (C, E) und einer Elektrode (G) eines isolierten Gates,
- einer zweiten spannungssteuerungsartigen Halbleitervorrichtung (MOSFET, 2) mit einer ersten Hauptelektrode, einer zweiten Hauptelektrode und einer Steuerungselektrode, wobei die erste Hauptelektrode mit der Elektrode (G) des isolierten Gates der ersten spannungssteuerungsartigen Halbleitervorrichtung (IGBT, 1) verbunden ist und die zweite Hauptelektrode mit einer der Hauptelektroden (E) der ersten spannungssteuerungsartigen Halbleitervorrichtung (IGBT, 1) verbunden ist, und
- einem Kapazitätselement (3), das zwischen die Steuerungselektrode der zweiten spannungssteuerungsartigen Halbleitervorrichtung (MOSFET, 2) und ein elektrisches Setzpotential (Va) geschaltet ist, wodurch die zweite spannungssteuerungsartige Halbleitervorrichtung (MOSFET, 2) angeschaltet wird.

2. Halbleiterschaltung nach Anspruch 1, **dadurch gekennzeichnet, daß** das elektrische Setzpotential (Va) an die andere Hauptelektrode (E) der ersten spannungssteuerungsartigen Halbleitervorrichtung (IGBT, 1) angelegt wird.

3. Halbleiterschaltung nach Anspruch 1, **dadurch gekennzeichnet, daß** das elektrische Setzpotential an eine Treiberschaltung der ersten spannungssteuerungsartigen Halbleitervorrichtung (IGBT, 1) angelegt wird.

4. Halbleiterschaltung nach einem der Ansprüche 1 bis 3, **dadurch gekennzeichnet, daß** das Kapazitätselement (3) mit einem MOSartigen Feldeffekttransistor (10) gebaut ist.

5. Halbleiterschaltung nach einem der Ansprüche 1 bis 3, **dadurch gekennzeichnet, daß** das Kapazitätselement (3) ein Kondensator ist.

6. Halbleiterschaltung nach einem der Ansprüche 1 bis 5, **dadurch gekennzeichnet, daß** die erste spannungssteuerungsartige Halbleitervorrichtung (IGBT, 1) ein Bipolartransistor mit isoliertem Gate ist.

7. Halbleiterschaltung nach einem der Ansprüche 1 bis 5, **dadurch gekennzeichnet, daß** die erste spannungssteuerungsartige Halbleitervorrichtung ein MOS-artiger Feldeffekttransistor ist.

8. Halbleiterschaltung nach einem der Ansprüche 1 bis 7, **dadurch gekennzeichnet, daß** die zweite spannungssteuerungsartige Halbleitervorrichtung ein MOS-artiger Feldeffekttransistor (MOSFET, 2) ist.

9. Halbleiterschaltung nach einem der Ansprüche 1 bis 7, **dadurch gekennzeichnet, daß** die zweite spannungssteuerungsartige Halbleitervorrichtung ein bipolarer Transistor mit isoliertem Gate ist.

10. Halbleiterschaltung mit
- mehreren ersten spannungssteuerungsartigen Halbleitervorrichtungen, die seriell verbunden sind und mit einer Gleichspannungsversorgung verbunden sind und die zwei Hauptelektroden sowie eine Elektrode eines isolierten Gates haben, wobei der Ausgang vom Serienverbindungspunkt der ersten spannungssteuerungsartigen Halbleitervorrichtungen abgegriffen wird,
- einer zweiten spannungssteuerungsartigen Halbleitervorrichtung mit einer ersten Hauptelektrode, einer zweiten Hauptelektrode und einer Steuerungselektrode, wobei die erste Hauptelektrode mit der Elektrode des isolierten Gates zumindest einer der ersten spannungssteuerungsartigen Halbleitervorrichtungen verbunden ist und die zweite Hauptelektrode mit einer der Hauptelektroden einer der spannungssteuerungsartigen ersten Halbleitervorrichtungen verbunden ist, und
- einem Kapazitätselement, das zwischen die Steuerungselektrode der zweiten spannungssteuerungsartigen Halbleitervorrichtung und ein elektrisches Setzpotential geschaltet ist, wodurch die zweite spannungssteuerungsartige Halbleitervorrichtung (MOSFET, 2) angeschaltet wird.

11. Wechselrichterschaltung mit einer oder mehreren Halbleiterschaltungen nach einem der Ansprüche 1 bis 10.

12. Monolithische Halbleiterschaltung, **gekennzeichnet durch** eine oder mehrere Halbleiterschaltungen nach einem der Ansprüche 1 bis 10 oder **durch** eine oder mehrere Wechselrichterschaltungen nach Anspruch 11, die auf dem gleichen Halbleitersubstrat aufgebaut sind.

13. Verwendung von Halbleiterschaltungen nach einem der Ansprüche 1 bis 10 für eine Vorrichtung mit einer oder mehreren Halbleiterschaltvorrichtungen zum Schützen der Halbleiterschaltvorrichtungen vor Fehlern oder Fehlfunktionen wegen Gate-Kurzschluß, wenn eine gefährliche Übergangsspannung (dV/dt) auftritt.

## Revendications

1. Circuit semi-conducteur comprenant :
- un premier dispositif semi-conducteur de type transmetteur de tension (IGBT, 1) ayant une paire d'électrodes principales (C, E) et une électrode de sortie isolée (G),
- un second dispositif semi-conducteur de type transmetteur de tension (MOSFET, 2) ayant une première électrode principale, une deuxième électrode principale et une électrode de commande, la première électrode principale étant connectée à l'électrode de sortie isolée (G) du premier dispositif semi-conducteur de type transmetteur de tension (IGBT, 1) et la deuxième électrode principale étant connectée à l'une des électrodes principales (E) du premier dispositif semi-conducteur de type transmetteur de tension (IGBT, 1), et
- un élément de capacité (3) connecté entre l'électrode de commande du deuxième dispositif semi-conducteur de type transmetteur de tension (MOSFET, 2) et un potentiel électrique d'accord (Va), de manière à ce que le second dispositif semi-conducteur de type transmetteur de tension (MOSFET, 2) soit en fonction.

2. Circuit semi-conducteur conformément à la revendication 1, **caractérisé en ce que** le potentiel électrique d'accord (Va) est appliqué à l'autre électrode principale (E) du premier dispositif semi-conducteur de type transmetteur de tension (IGBT, 1).

3. Circuit semi-conducteur conformément à la revendication 1, **caractérisé en ce que** le potentiel électrique d'accord est appliqué à un circuit transmetteur du premier dispositif semi-conducteur de type transmetteur de tension (IGBT, 1).

4. Circuit semi-conducteur conformément à l'une quelconque des revendications 1 à 3, **caractérisé en ce que** l'élément de capacité (3) est construit avec un transistor à effet de champ de type MOS (10).

5. Circuit semi-conducteur conformément à l'une quelconque des revendications 1 à 3, **caractérisé en ce que** l'élément de capacité (3) est un condensateur.

6. Circuit semi-conducteur conformément à l'une quelconque des revendications 1 à 5, **caractérisé en ce que** le premier dispositif semi-conducteur de type transmetteur de tension (IGBT, 1) est un transistor bipolaire à sortie isolée.

7. Circuit semi-conducteur conformément à l'une quelconque des revendications 1 à 5, **caractérisé en ce que** le premier dispositif semi-conducteur de type transmetteur de tension est un transistor à effet de champ de type MOS.

8. Circuit semi-conducteur conformément à l'une quelconque des revendications 1 à 7, **caractérisé en ce que** le deuxième dispositif semi-conducteur de type transmetteur de tension est un transistor à effet de champ de type MOS (MOSFET, 2).

9. Circuit semi-conducteur conformément à l'une quelconque des revendications 1 à 7, **caractérisé en ce que** le deuxième dispositif semi-conducteur de type transmetteur de tension est un transistor bipolaire à sortie isolée.

10. Circuit semi-conducteur comprenant :
- une pluralité de premiers dispositifs semi-conducteurs de type transmetteur de tension connectés en série et connectés à une alimentation électrique continue, ayant une paire d'électrodes principales et une électrode de sortie isolée, où l'on prend une sortie parmi la série de points de connexion des premiers dispositifs semi-conducteurs de type transmetteur de tension,
- un second dispositif semi-conducteur de type transmetteur de tension ayant une première électrode principale, une deuxième électrode principale et une électrode de commande, la première électrode principale étant connectée à l'électrode de sortie isolée d'au moins l'un des premiers dispositifs semi-conducteurs de type transmetteur de tension et une deuxième électrode principale étant connectée à l'une des électrodes principales de l'un des premiers dispositifs semi-conducteurs de type transmetteur de tension, et
- un élément de capacité connecté à l'électrode de commande du deuxième dispositif semi-conducteur de type transmetteur de tension et à un potentiel électrique d'accord, de manière à ce que le deuxième dispositif semi-conducteur de type transmetteur de tension (MOSFET, 2) soit en fonction.

11. Circuit onduleur comprenant un ou une pluralité de circuits semi-conducteurs conformément à l'une des revendications 1 à 10.

12. Circuit semi-conducteur monolithique, **caractérisé par** un ou une pluralité de circuits semi-conducteurs conformément à l'une des revendications 1 à 10 ou un ou une pluralité de circuits onduleurs conformément à revendication 11, sont montés sur le même substrat semi-conducteur.

13. Utilisation des circuits semi-conducteurs conformément aux revendications 1 à 12 pour des appareils comprenant un ou une pluralité de dispositifs de commutation semi-conducteurs pour protéger les dispositifs de commutation semi-conducteurs des défaillances ou des dysfonctionnements par un court circuit de sortie au cas où il apparaîtrait une tension transitoire dangereuse (dV/dt).
